# EUROPEAN PATENT APPLICATION

(11) **EP 4 534 850 A1**
(43) Date of publication of application: **09.04.2025**
(21) Application number: 23811736.0
(22) Date of filing: 18.05.2023
(51) Int. Cl.: F04D 19/04

(54) **VACUUM PUMP AND VACUUM EVACUATION SYSTEM**

(30) Priority: 26.05.2022 JP 2022086185
(71) Applicant: Edwards Japan Limited, Yachiyo-shi, Chiba 276-8523 (JP)
(72) Inventor: KABASAWA, Takashi, Yachiyo-shi Chiba 276-8523 (JP)
(74) Representative: Openshaw & Co.
(86) International application number: PCT/JP2023/018623
(87) International publication number: WO 2023/228863

(57) **Abstract**

A vacuum pump and a vacuum exhaust system are provided that can improve the cleaning efficiency of a radical generator, effectively clear reaction products accumulating in the vacuum pump with fewer radical generators, and also reduce operating costs. A radical supply port 134A is disposed adjacent to an exhaust side outlet of an exhaust mechanism 132 and provided to extend through a housing 110A, and a radical supply means 135 supplies radicals 136 into the housing 110A through the radical supply port 134A and causes the supplied radicals 136 to flow to an area in which reaction products accumulate in the exhaust mechanism 132.

## Description

The present invention relates to a vacuum pump and a vacuum exhaust system, and more particularly to a vacuum pump and a vacuum exhaust system that can be used in a pressure range from low vacuum to ultrahigh vacuum.

The manufacturing of semiconductor devices, such as memories and integrated circuits, requires implementation of doping and etching on high-purity semiconductor substrates (wafers) in a state of high-vacuum in a chamber to avoid influences of dust or the like in air. To exhaust the chamber, a vacuum pump, such as a turbomolecular pump, is used.

A known vacuum pump of this type has a cylindrical casing, a cylindrical stator, which is nested in and fixed to the casing and has a thread groove, and a rotor, which is supported in the stator so as to be rotatable at high speed.

With a vacuum pump, depending on the gas drawn through an inlet port of the casing, the gas may undergo a phase change into a solid while being compressed inside the pump (inside the casing) and thus solidify in the pump. As a result, solidified substances (hereinafter referred to as "reaction products") may accumulate in the pump, resulting in a problem of a blocked gas passage.

Japanese Patent Application Publication No. 2008-248825, for example, proposes a technique for solving the above problem by supplying radicals into the vacuum pump to clear reaction products.

The radicals are used to remove the solidified substances accumulating in the pump by applying a high voltage to a material gas such as nitrogen trifluoride (NF3) and forcibly peeling off and activating the solidified substances. However, radicals become inactive when coming into contact with the introduction pipe, through which the radicals are introduced into the pump, and surfaces of components of the pump. As such, when a radical generator is placed in the vicinity of the inlet port of the vacuum pump as in the Japanese Patent Application Publication No. 2008-248825, although a cleaning effect is higher in the vicinity of the inlet port, most of the reaction products accumulating in the vicinity of the outlet port are unlikely to be cleared.

However, the reaction products often accumulate in the vicinity of the outlet port of the vacuum pump, and thus the vicinity of the outlet port requires effective cleaning. To this end, Japanese Patent Application Publication No. 2022-17864, for example, proposes a vacuum pump that uses a technique for delivering radicals to a portion that has to be cleaned before the radicals become inactive by placing a radical generator not only in the vicinity of the inlet port but also in the vicinity of a middle section of an exhaust mechanism of the vacuum pump.

However, although the vacuum pump described in the Japanese Patent Application Publication No. 2022-17864 can effectively clean both the vicinity of the inlet port and the vicinity of the outlet port, it requires radical generators placed at multiple positions, resulting in a higher cost.

Also, the radicals supplied into the vacuum pump of the Japanese Patent Application Publication No. 2022-17864 flow in one direction from the inlet port toward the outlet port. As such, when a radical supply port is placed in the vicinity of the center of an area in which reaction products accumulate, for example, an upstream side of the radical supply port is not cleaned, although a downstream side of the radical supply port is cleaned. To clean the upstream side of the radical supply port, an additional radical supply port for cleaning the upstream side is required.

In view of the foregoing, it is an object of the present invention to solve technical problems that need to be solved and provide a vacuum pump and a vacuum exhaust system that improve the cleaning efficiency of a radical generator, effectively clear reaction products accumulating in the vacuum pump with fewer radical generators, and also reduce operating costs.

The present invention has been proposed to achieve the above object. The invention according to claim 1 proposes a vacuum pump including: a housing having an inlet port and an outlet port; an exhaust mechanism disposed inside the housing, the vacuum pump further including: a radical supply port that is disposed adjacent to an exhaust side outlet of the exhaust mechanism and provided to extend through the housing; and a radical supply means for supplying radicals into the housing through the radical supply port and causing the supplied radicals to flow to an area in which reaction products accumulate in the exhaust mechanism.

According to the configuration, radicals are supplied into the housing through the radical supply port provided between the outlet port and the inlet port, and the radical path is switched between a path through which the radicals flow from the radical supply port to the downstream side and a path through which the radicals flow from the radical supply port to the upstream side. Thus, the supplied radicals are distributed over the entire area that requires cleaning in the housing. Also, the reaction products accumulating in the exhaust mechanism or the like in the housing can be activated and effectively removed. As a result, the effective removal of reaction products is achieved with a fewer number of radical generators, thereby reducing both the cost of cleaning components of the cleaning system in the vacuum pump and the operating costs.

The invention according to claim 2 provides the vacuum pump according to claim 1 further including an intermediate port located between the inlet port and the radical supply port to discharge the radicals to outside of the housing.

According to this configuration, the radicals supplied through the radical supply port can be discharged to outside of the housing not only through the outlet port but also through the intermediate port. That is, the cleaning effect can be maximized by providing the intermediate port at a position that allows for the activation and effective removal of reaction products accumulating in the exhaust mechanism in the housing and by causing the radicals to be discharged to outside of the housing through the intermediate port when necessary. The configuration also stops the removed reaction products from flowing to the upstream side, thereby preventing the contamination of the upstream side.

The invention according to claim 3 provides the vacuum pump according to claim 2 further including: a suction and exhaust means capable of drawing the radicals supplied into the housing through the outlet port or the intermediate port and discharging the radicals to outside of the housing; and an exhaust switching valve capable of switching a discharge path of the radicals to the outlet port or the intermediate port.

According to this configuration, the radicals supplied into the housing through the radical supply port can be discharged to outside of the housing through the outlet port or the intermediate port by a switching operation of the discharge path by the exhaust switching valve. As such, the cleaning effect can be maximized by selecting a position of the outlet port or the intermediate port that allows for the activation and effective removal of reaction products accumulating in the exhaust mechanism in the housing and by switching the discharge path of the radicals with the exhaust switching valve.

The invention according to claim 4 provides the vacuum pump according to claim 1, wherein at least a part of the exhaust mechanism is a turbomolecular pump mechanism including a rotating body having a plurality of rotor blades arranged in multiple stages in an axial direction and a plurality of stator blades disposed between the plurality of rotor blades.

According to this configuration, in the exhaust mechanism, at least a part of which is a turbomolecular pump mechanism including a rotating body having a plurality of rotor blades arranged in multiple stages in an axial direction and a plurality of stator blades disposed between the rotor blades, the reaction products accumulating in the exhaust mechanism in the housing can be activated and effectively removed.

The invention according to claim 5 provides the vacuum pump according to claim 1, wherein at least a part of the exhaust mechanism is a Siegbahn type pump mechanism including a rotating disc, a stator disc, and a spiral groove provided in at least a part of an opposed surface of the stator disc facing the rotating disc.

According to this configuration, in the exhaust mechanism, at least a part of which is a Siegbahn type pump mechanism including a rotating disc, a stator disc, and a spiral groove provided in at least a part of an opposed surface of the stator disc facing the rotating disc, the reaction products accumulating in the exhaust mechanism in the housing can be activated and effectively removed.

The invention according to claim 6 provides the vacuum pump according to claim 1, wherein at least a part of the exhaust mechanism is a Holweck type pump mechanism including a rotating cylinder, a stator cylinder, and a thread groove provided in at least a part of an opposed surface of the stator cylinder facing the rotating cylinder.

According to this configuration, in the exhaust mechanism, at least a part of which is a Holweck type pump mechanism including a rotating cylinder, a stator cylinder, and a thread groove provided in at least a part of an opposed surface of the stator cylinder facing the rotating cylinder, the reaction products accumulating in the exhaust mechanism in the housing can be activated and effectively removed.

The invention according to claim 7 provides the vacuum pump according to claim 2, wherein the exhaust mechanism is constituted of at least two of a turbomolecular pump mechanism including a rotating body having a plurality of rotor blades arranged in multiple stages in an axial direction and a plurality of stator blades disposed between the plurality of rotor blades, a Siegbahn type pump mechanism including a rotating disc, a stator disc, and a spiral groove provided in at least a part of an opposed surface of the stator disc facing the rotating disc, or a Holweck type pump mechanism including a rotating cylinder, a stator cylinder, and a thread groove provided in at least a part of an opposed surface of the stator cylinder facing the rotating cylinder, and the intermediate port is disposed in a vicinity of a boundary between adjacent ones of the turbomolecular pump mechanism, the Siegbahn type pump mechanism, or the Holweck type pump mechanism.

According to this configuration, in the vacuum pump in which at least a part of the exhaust mechanism includes at least two of a Siegbahn type pump mechanism including a rotating disc, a stator disc, and a spiral groove provided in at least a part of an opposed surface of the stator disc facing the rotating disc, or a Holweck type pump mechanism including a rotating cylinder, a stator cylinder, and a thread groove provided in at least a part of an opposed surface of the stator cylinder facing the rotating cylinder, the reaction products accumulating in the exhaust mechanism in the housing can be activated and effectively removed.

The invention according to claim 8 provides a vacuum exhaust system including: a vacuum pump including: a housing having an inlet port and an outlet port, an exhaust mechanism disposed inside the housing, and a radical supply port that is disposed adjacent to an exhaust side outlet of the exhaust mechanism and provided to extend through the housing; and a radical supply means for supplying radicals into the housing through the radical supply port and causing the supplied radicals to be supplied to an area in which reaction products accumulate in the exhaust mechanism.

According to the configuration, radicals are supplied into the housing through the radical supply port provided between the outlet port and the inlet port, and the radical path is switched between a path through which the radicals flow from the radical supply port to the downstream side and a path through which the radicals flow from the radical supply port to the upstream side. Thus, the supplied radicals are distributed over the entire area that requires cleaning in the housing. Also, the reaction products accumulating in the exhaust mechanism or the like in the housing can be activated and effectively removed. As a result, the effective removal of reaction products is achieved with a fewer number of radical generators. A vacuum exhaust system is thus achieved that can reduce both the cost of cleaning components of the cleaning system in the vacuum pump and the operating costs.

According to the present invention, when radicals are supplied into the housing through a radical supply port provided between the inlet port and the outlet port, the supplied radicals are distributed over the entire area that requires cleaning in the housing, and activate the reaction products accumulating in the exhaust mechanism or the like in the housing, thereby effectively removing the reaction products. As a result, the effective removal of reaction products is achieved with a fewer number of radical generators, thereby reducing both the cost of cleaning components of the cleaning system in the vacuum pump and the operating costs.
FIG. 1 is a vertical cross-sectional view of a turbomolecular pump as a first example of a vacuum pump according to an embodiment of the present invention, illustrating a discharge path that is switched to a state in which radicals are discharged through an intermediate port;
FIG. 2 is a vertical cross-sectional view of the turbomolecular pump as the first example of a vacuum pump according to an embodiment of the present invention, illustrating a discharge path that is switched to a state in which radicals are discharged through an outlet port;
FIG. 3 is a diagram showing an example of an amplifier circuit in the turbomolecular pump of the first example;
FIG. 4 is a time chart showing an example of control performed when a current command value detected by the amplifier circuit in the turbomolecular pump of the first example is greater than a detected value;
FIG. 5 is a time chart showing an example of control performed when a current command value detected by the amplifier circuit in the turbomolecular pump of the first example is less than a detected value;
FIG. 6 is a vertical cross-sectional view of a turbomolecular pump as a second example of a vacuum pump according to an embodiment of the present invention;
FIG. 7 is a vertical cross-sectional view of a turbomolecular pump as a third example of a vacuum pump according to an embodiment of the present invention;
FIG. 8 is a vertical cross-sectional view of a turbomolecular pump as a fourth example of a vacuum pump according to an embodiment of the present invention; and
FIG. 9 is a vertical cross-sectional view of a turbomolecular pump as a fifth example of a vacuum pump according to an embodiment of the present invention.

To achieve the object of providing a vacuum pump and a vacuum exhaust system that improve the cleaning efficiency of a radical generator, effectively clear reaction products accumulating in the vacuum pump with fewer radical generators, and also reduce the operating costs, the present invention is directed to a vacuum pump including: a housing having an inlet port and an outlet port; an exhaust mechanism disposed inside the housing; a radical supply port that is disposed adjacent to an exhaust side outlet of the exhaust mechanism and extends through the housing; and a radical supply means configured to supply radicals into the housing through the radical supply port and cause the supplied radicals to flow to an area in which reaction products accumulate in the exhaust mechanism. Examples

Referring to the accompanying drawings, examples according to embodiments of the present invention are described in detail. In the following examples, when reference is made to the number, numerical value, amount, range, or the like of components, it is not limited to the specific number, and may be greater than or less than the specific number, unless specified otherwise or clearly limited to the specific number in principle.

Also, when reference is made to the shape and positional relationship of components and the like, those that are substantially analogous or similar to the shape and the like are included unless specified otherwise or the content clearly dictates otherwise in principle.

In the drawings, characteristic parts may be enlarged or otherwise exaggerated to improve understanding of the characteristics, and components are not necessarily drawn to scale. In cross-sectional views, hatch patterns of some components may be omitted to improve understanding of the cross-sectional structure of the components.

In the following description, the expressions indicating directions, such as up, down, left, and right, are not absolute and are appropriate when the portions of the vacuum pump of the present invention are in the orientation shown in the drawing, and should be interpreted with a change according to any change in the orientation. Additionally, the same elements are designated by the same reference numerals throughout the description of the examples.

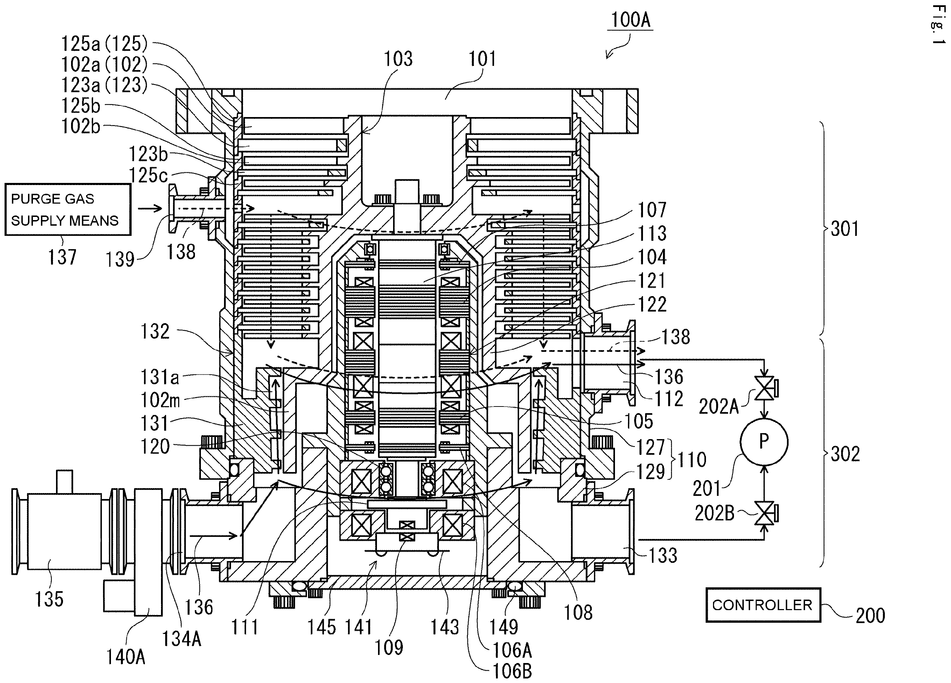

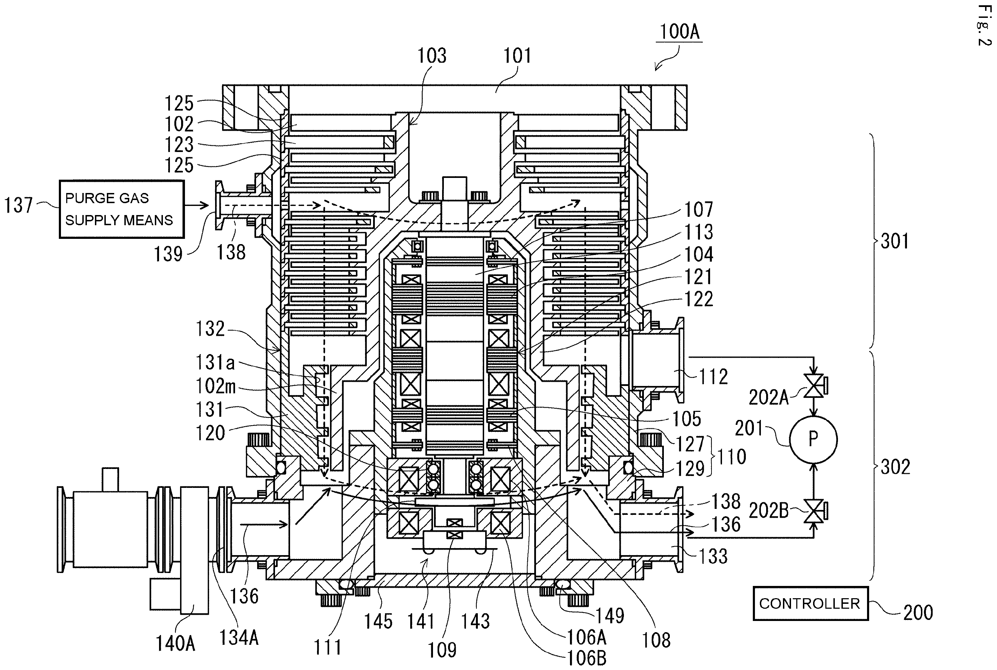

FIGS. 1 and 2 are vertical cross-sectional views of a turbomolecular pump 100A. As shown in FIGS. 1 and 2, the turbomolecular pump 100A includes a circular outer cylinder 127, which serves as a housing and has an inlet port 101 at its upper end. A rotating body 103 in the outer cylinder 127 includes a plurality of rotor blades 102 (102a, 102b, 102c, ...), which are turbine blades for gas suction and exhaustion, in its outer circumference section. The rotor blades 102 extend radially in multiple stages. The rotating body 103 has a rotor shaft 113 in its center. The rotor shaft 113 is suspended in the air and position-controlled by a magnetic bearing of 5-axis control, for example.

Upper radial electromagnets 104 include four electromagnets arranged in pairs on an X-axis and a Y-axis. Four upper radial sensors 107 are provided in close proximity to the upper radial electromagnets 104 and associated with the respective upper radial electromagnets 104. Each upper radial sensor 107 may be an inductance sensor or an eddy current sensor having a conduction winding, for example, and detects the position of the rotor shaft 113 based on a change in the inductance of the conduction winding, which changes according to the position of the rotor shaft 113. The upper radial sensors 107 are configured to detect a radial displacement of the rotor shaft 113, that is, the rotating body 103 fixed to the rotor shaft 113, and send it to the controller 200.

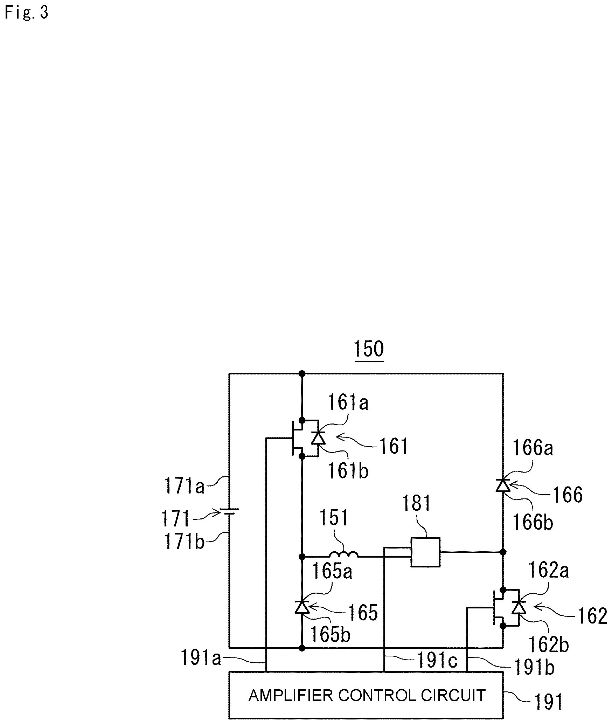

In the controller 200, for example, a compensation circuit having a PID adjustment function generates an excitation control command signal for the upper radial electromagnets 104 based on a position signal detected by the upper radial sensors 107. Based on this excitation control command signal, an amplifier circuit 150 (described below) shown in FIG. 3 controls and excites the upper radial electromagnets 104 to adjust a radial position of an upper part of the rotor shaft 113.

The rotor shaft 113 may be made of a high magnetic permeability material (such as iron and stainless steel) and is configured to be attracted by magnetic forces of the upper radial electromagnets 104. The adjustment is performed independently in the X-axis direction and the Y-axis direction. Lower radial electromagnets 105 and lower radial sensors 108 are arranged in a similar manner as the upper radial electromagnets 104 and the upper radial sensors 107 to adjust the radial position of the lower part of the rotor shaft 113 in a similar manner as the radial position of the upper part.

Additionally, axial electromagnets 106A and 106B are arranged so as to vertically sandwich a metal disc 111, which has a shape of a circular disc and is provided in the lower part of the rotor shaft 113. The metal disc 111 is made of a high magnetic permeability material such as iron. An axial sensor 109 is provided to detect an axial displacement of the rotor shaft 113 and send an axial position signal to the controller 200.

In the controller 200, the compensation circuit having the PID adjustment function may generate an excitation control command signal for each of the axial electromagnets 106A and 106B based on the signal on the axial position detected by the axial sensor 109. Based on these excitation control command signals, the amplifier circuit 150 controls and excites the axial electromagnets 106A and 106B separately so that the axial electromagnet 106A magnetically attracts the metal disc 111 upward and the axial electromagnet 106B attracts the metal disc 111 downward. The axial position of the rotor shaft 113 is thus adjusted.

As described above, the controller 200 appropriately adjusts the magnetic forces exerted by the axial electromagnets 106A and 106B on the metal disc 111, magnetically levitates the rotor shaft 113 in the axial direction, and suspends the rotor shaft 113 in the air in a non-contact manner. The amplifier circuit 150, which controls and excites the upper radial electromagnets 104, the lower radial electromagnets 105, and the axial electromagnets 106A and 106B, is described below.

The motor 121 includes a plurality of magnetic poles circumferentially arranged to surround the rotor shaft 113. Each magnetic pole is controlled by the controller 200 so as to drive and rotate the rotor shaft 113 via an electromagnetic force acting between the magnetic pole and the rotor shaft 113. The motor 121 also includes a rotational speed sensor (not shown), such as a Hall element, a resolver, or an encoder, and the rotational speed of the rotor shaft 113 is detected based on a detection signal of the rotational speed sensor.

Furthermore, a phase sensor (not shown) is attached adjacent to the lower radial sensors 108 to detect the phase of rotation of the rotor shaft 113. The controller 200 detects the position of the magnetic poles using both detection signals of the phase sensor and the rotational speed sensor.

A plurality of stator blades 123a, 123b, 123c, ... are arranged slightly spaced apart from the rotor blades 102 (102a, 102b, 102c, ...). Each rotor blade 102 (102a, 102b, 102c, ...) is inclined by a predetermined angle from a plane perpendicular to the axis of the rotor shaft 113 in order to transfer exhaust gas molecules downward through collision.

The stator blades 123 are also inclined by a predetermined angle from a plane perpendicular to the axis of the rotor shaft 113. The stator blades 123 extend inward of the outer cylinder 127 and alternate with the stages of the rotor blades 102. The outer circumference ends of the stator blades 123 are inserted between and thus supported by a plurality of layered stator blade spacers 125 (125a, 125b, 125c, ...).

The stator blade spacers 125 are ring-shaped members made of a metal, such as aluminum, iron, stainless steel, or copper, or an alloy containing these metals as components, for example. The outer cylinder 127 is fixed to the outer circumferences of the stator blade spacers 125 with a slight gap. A base portion 129 is located at the base of the outer cylinder 127. The base portion 129 has an outlet port 133 providing communication to the outside. The exhaust gas transferred to the base portion 129 through the inlet port 101 from the chamber is then sent to the outlet port 133.

According to the application of the turbomolecular pump 100A, a threaded spacer 131 may be provided between the lower part of the stator blade spacer 125 and the base portion 129. The threaded spacer 131 is a cylindrical member made of a metal such as aluminum, copper, stainless steel, or iron, or an alloy containing these metals as components. The threaded spacer 131 has a plurality of helical thread grooves 131a in its inner circumference surface. When exhaust gas molecules move in the rotation direction of the rotating body 103, these molecules are transferred toward the outlet port 133 in the direction of the helix of the thread grooves 131a. In the lowermost section of the rotating body 103 below the rotor blades 102 (102a, 102b, 102c, ...), a cylindrical portion 102m extends downward. The outer circumference surface of the cylindrical portion 102m is cylindrical and projects toward the inner circumference surface of the threaded spacer 131. The outer circumference surface is adjacent to but separated from the inner circumference surface of the threaded spacer 131 by a predetermined gap. The exhaust gas transferred to the thread grooves 131a by the rotor blades 102 and the stator blades 123 is guided by the thread grooves 131a to the base portion 129.

The base portion 129 is a disc-shaped member forming the base section of the turbomolecular pump 100A, and is generally made of a metal such as iron, aluminum, or stainless steel. The base portion 129 physically holds the turbomolecular pump 100A and also serves as a heat conduction path. As such, the base portion 129 is preferably made of rigid metal with high thermal conductivity, such as iron, aluminum, or copper.

In this configuration, when the motor 121 drives and rotates the rotor blades 102 together with the rotor shaft 113, the interaction between the rotor blades 102 and the stator blades 123 causes the suction of exhaust gas from the chamber through the inlet port 101. The exhaust gas taken through the inlet port 101 moves between the rotor blades 102 and the stator blades 123 and is transferred to the base portion 129. At this time, factors such as the friction heat generated when the exhaust gas comes into contact with the rotor blades 102 and the conduction of heat generated by the motor 121 increase the temperature of the rotor blades 102. This heat is conducted to the stator blades 123 through radiation or conduction via gas molecules of the exhaust gas, for example.

The stator blade spacers 125 are joined to each other at the outer circumference portion and conduct the heat received by the stator blades 123 from the rotor blades 102, the friction heat generated when the exhaust gas comes into contact with the stator blades 123, and the like to the outside.

In the above description, the threaded spacer 131 is provided at the outer circumference of the cylindrical portion 102m of the rotating body 103, and the thread grooves 131a are engraved in the inner circumference surface of the threaded spacer 131. However, this may be inversed in some cases, and a thread groove may be engraved in the outer circumference surface of the cylindrical portion 102m, while a spacer having a cylindrical inner circumference surface may be arranged around the outer circumference surface.

According to the application of the turbomolecular pump 100A, to prevent the gas drawn through the inlet port 101 from entering an electrical portion, which includes the upper radial electromagnets 104, the upper radial sensors 107, the motor 121, the lower radial electromagnets 105, the lower radial sensors 108, the axial electromagnets 106A, 106B, and the axial sensor 109, the electrical portion may be surrounded by a stator column 122. The inside of the stator column 122 may be maintained at a predetermined pressure by purge gas.

In this case, the base portion 129 has a pipe (not shown) through which the purge gas is introduced. The introduced purge gas is sent to the outlet port 133 through gaps between a protective bearing 120 and the rotor shaft 113, between the rotor and the stator of the motor 121, and between the stator column 122 and the inner circumference cylindrical portion of the rotor blade 102.

The turbomolecular pump 100A requires the identification of the model and control based on individually adjusted unique parameters (for example, various characteristics associated with the model). To store these control parameters, the turbomolecular pump 100A includes an electronic circuit portion 141 in its main body. The electronic circuit portion 141 may include a semiconductor memory, such as an EEPROM, electronic components such as semiconductor elements for accessing the semiconductor memory, and a substrate 143 for mounting these components. The electronic circuit portion 141 is housed under a rotational speed sensor (not shown) near the center, for example, of the base portion 129, which forms the lower part of the turbomolecular pump 100A, and is closed by an airtight bottom lid 145.

Some process gas introduced into the chamber in the manufacturing process of semiconductors has the property of becoming solid when its pressure becomes higher than a predetermined value or its temperature becomes lower than a predetermined value. In the turbomolecular pump 100A, the pressure of the exhaust gas is lowest at the inlet port 101 and highest at the outlet port 133. When the pressure of the process gas increases beyond a predetermined value or its temperature decreases below a predetermined value while the process gas is being transferred from the inlet port 101 to the outlet port 133, the process gas is solidified and adheres and accumulates on the inner side of the turbomolecular pump 100A.

For example, when SiCl4 is used as the process gas in an Al etching apparatus, according to the vapor pressure curve, a solid product (for example, AlCl3) is deposited at a low vacuum (760 [torr] to 10-2 [torr]) and a low temperature (about 20 [°C]) and adheres and accumulates on the inner side of the turbomolecular pump 100A. When the deposit of the process gas accumulates in the turbomolecular pump 100A, the accumulation may narrow the pump flow passage and degrade the performance of the turbomolecular pump 100A. The above-mentioned product tends to solidify and adhere in areas with higher pressures, such as the vicinity of the outlet port and the vicinity of the threaded spacer 131.

To solve this problem, conventionally, a heater or annular water-cooled tube 149 (not shown) is wound around the outer circumference of the base portion 129, and a temperature sensor (e.g., a thermistor, not shown) is embedded in the base portion 129, for example. The signal of this temperature sensor is used to perform control to maintain the temperature of the base portion 129 at a constant high temperature (preset temperature) by heating with the heater or cooling with the water-cooled tube 149 (hereinafter referred to as TMS (temperature management system)).

The amplifier circuit 150 is now described that controls and excites the upper radial electromagnets 104, the lower radial electromagnets 105, and the axial electromagnets 106A and 106B of the turbomolecular pump 100A configured as described above. FIG. 3 is a circuit diagram of the amplifier circuit 150.

In FIG. 3, one end of an electromagnet winding 151 forming an upper radial electromagnet 104 or the like is connected to a positive electrode 171a of a power supply 171 via a transistor 161, and the other end is connected to a negative electrode 171b of the power supply 171 via a current detection circuit 181 and a transistor 162. Each transistor 161, 162 is a power MOSFET and has a structure in which a diode is connected between the source and the drain thereof.

In the transistor 161, a cathode terminal 161a of its diode is connected to the positive electrode 171a, and an anode terminal 161b is connected to one end of the electromagnet winding 151. In the transistor 162, a cathode terminal 162a of its diode is connected to a current detection circuit 181, and an anode terminal 162b is connected to the negative electrode 171b.

A diode 165 for current regeneration has a cathode terminal 165a connected to one end of the electromagnet winding 151 and an anode terminal 165b connected to the negative electrode 171b. Similarly, a diode 166 for current regeneration has a cathode terminal 166a connected to the positive electrode 171a and an anode terminal 166b connected to the other end of the electromagnet winding 151 via the current detection circuit 181. The current detection circuit 181 may include a Hall current sensor or an electric resistance element, for example.

The amplifier circuit 150 configured as described above corresponds to one electromagnet. Accordingly, when the magnetic bearing uses 5-axis control and has ten electromagnets 104, 105, 106A, and 106B in total, an identical amplifier circuit 150 is configured for each of the electromagnets. These ten amplifier circuits 150 are connected to the power supply 171 in parallel.

An amplifier control circuit 191 may be formed by a digital signal processor portion (not shown, hereinafter referred to as a DSP portion) of the controller 200. The amplifier control circuit 191 switches the transistors 161 and 162 between on and off.

The amplifier control circuit 191 is configured to compare a current value detected by the current detection circuit 181 (a signal reflecting this current value is referred to as a current detection signal 191c) with a predetermined current command value. The result of this comparison is used to determine the magnitude of the pulse width (pulse width time Tp1, Tp2) generated in a control cycle Ts, which is one cycle in PWM control. As a result, gate drive signals 191a and 191b having this pulse width are output from the amplifier control circuit 191 to gate terminals of the transistors 161 and 162.

Under certain circumstances such as when the rotational speed of the rotating body 103 reaches a resonance point during acceleration, or when a disturbance occurs during a constant speed operation, the rotating body 103 may require positional control at high speed and with a strong force. For this purpose, a high voltage of about 50 V, for example, is used for the power supply 171 to enable a rapid increase (or decrease) in the current flowing through the electromagnet winding 151. Additionally, a capacitor is generally connected between the positive electrode 171a and the negative electrode 171b of the power supply 171 to stabilize the power supply 171 (not shown).

In this configuration, when both transistors 161 and 162 are turned on, the current flowing through the electromagnet winding 151 (hereinafter referred to as an electromagnet current iL) increases, and when both are turned off, the electromagnet current iL decreases.

Also, when one of the transistors 161 and 162 is turned on and the other is turned off, a freewheeling current is maintained. Passing the freewheeling current through the amplifier circuit 150 in this manner reduces the hysteresis loss in the amplifier circuit 150, thereby limiting the power consumption of the entire circuit to a low level. Moreover, by controlling the transistors 161 and 162 as described above, high frequency noise, such as harmonics, generated in the turbomolecular pump 100A can be reduced. Furthermore, by measuring this freewheeling current with the current detection circuit 181, the electromagnet current iL flowing through the electromagnet winding 151 can be detected.

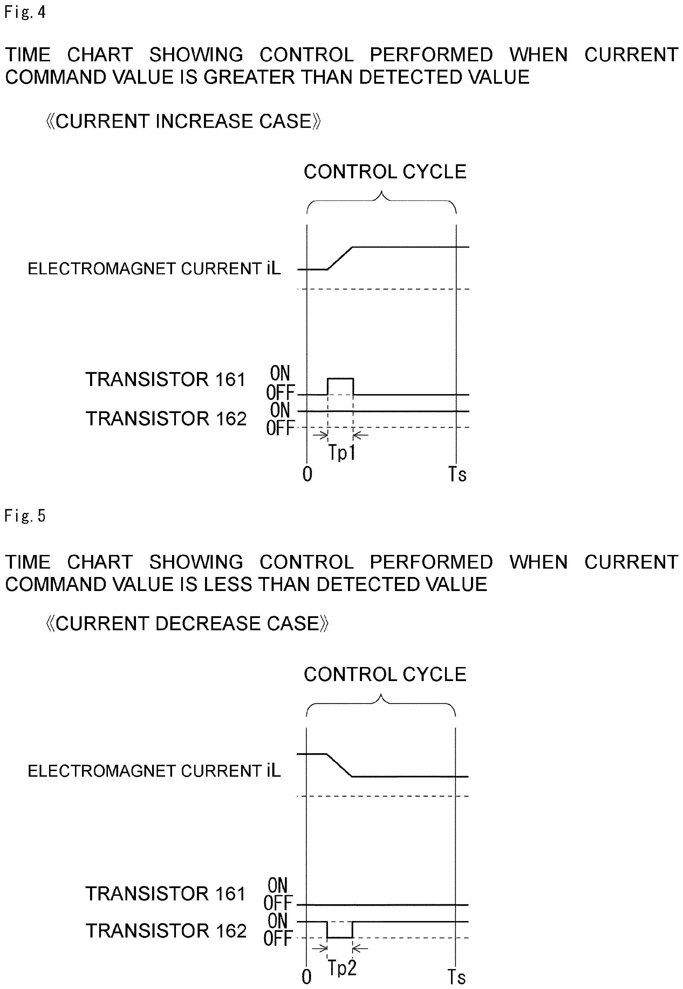

That is, when the detected current value is smaller than the current command value, as shown in FIG. 4, the transistors 161 and 162 are simultaneously on only once in the control cycle Ts (for example, 100 µs) for the time corresponding to the pulse width time Tp1. During this time, the electromagnet current iL increases accordingly toward the current value iLmax (not shown) that can be passed from the positive electrode 171a to the negative electrode 171b via the transistors 161 and 162.

When the detected current value is larger than the current command value, as shown in FIG. 5, the transistors 161 and 162 are simultaneously off only once in the control cycle Ts for the time corresponding to the pulse width time Tp2. During this time, the electromagnet current iL decreases accordingly toward the current value iLmin (not shown) that can be regenerated from the negative electrode 171b to the positive electrode 171a via the diodes 165 and 166.

In either case, after the pulse width time Tp1, Tp2 has elapsed, one of the transistors 161 and 162 is on. During this period, the freewheeling current is thus maintained in the amplifier circuit 150.

With the turbomolecular pump 100A described above, depending on the gas drawn through the inlet port 101 of the housing 110A, which includes the outer cylinder 127 and the base portion 129 and is formed substantially in a cylindrical shape, the gas may undergo a phase change into a solid while being compressed in the housing 110A and thus solidify in the housing 110A. As a result, solidified substances (hereinafter referred to as "reaction products") may accumulate in the housing 110A, resulting in a problem of a blocked gas passage.

Also, the turbomolecular pump 100A of the first example includes an exhaust mechanism 132, which forms a turbomolecular pump mechanism portion 301 on the upstream side and forms a thread groove pump mechanism portion 302 on the downstream side in the housing 110A. The turbomolecular pump mechanism portion 301 includes the rotating body 103 having a plurality of rotor blades 102 arranged in multiple stages in the axial direction and a plurality of stator blades 123 disposed between the rotor blades 102. The thread groove pump mechanism portion 302 includes the cylindrical portion 102m, which is a rotating cylinder that rotates integrally with the rotating body 103, the threaded spacer 131, which is a stator cylinder, and the thread grooves 131a provided in the inner circumference surface of the threaded spacer 131, which is an opposed surface facing the outer circumference surface of the rotating cylindrical portion 102m. The thread groove pump mechanism portion 302 is configured as a Holweck type pump mechanism. Additionally, an intermediate port 112 extends through the housing 110A in a portion substantially midway between the upstream side and the downstream side in the housing 110A, that is, in the vicinity of the boundary between the turbomolecular pump mechanism portion 301 and the thread groove pump mechanism portion 302, which is configured as a Holweck type pump mechanism. Furthermore, a radical supply port 134A extends through the housing 110A adjacent to the outlet port 133, that is, adjacent to the exhaust side outlet of the exhaust mechanism 132. A radical supply means 135, which is connected to the radical supply port 134A, supplies radicals 136 into the housing 110A through the radical supply port 134A and causes the supplied radicals 136 to flow to an area in which reaction products accumulate in the exhaust mechanism 132. These radicals 136 activate and remove the reaction products accumulating in the exhaust mechanism 132, for example. The controller 200 controls the supply of radicals 136 from the radical supply means 135 so that an appropriate amount of radicals are supplied. Additionally, an on-off valve 140A is located between the radical supply means 135 and the radical supply port 134A to perform on-off control of the supply of radicals 136 from the radical supply means 135. The controller 200 controls the opening and closing of the on-off valve 140A.

Furthermore, a purge gas supply port 139 is provided between the inlet port 101 and the outlet port 133 of the housing 110A to supply a purge gas 138 into the housing 110A from a purge gas supply means 137. The purge gas supply port 139 is provided on the upstream side (the side corresponding to the turbomolecular pump mechanism portion 301) of the intermediate port 112 and on the downstream side of the inlet port 101. The controller 200 controls the supply of purge gas 138 from the purge gas supply means 137 so that an appropriate amount of purge gas is supplied.

The radicals 136 may be fluorine radicals that can remove solidified substances accumulating in the housing 110A and are produced by applying a high voltage to a material gas such as nitrogen trifluoride (NF3), for example. The purge gas 138 may be an inert gas, such as nitrogen gas (N2), that serves to carry the radicals 136 to the downstream side. That is, when the radicals 136 supplied into the housing 110A through the radical supply port 134A flow in the housing 110A toward the inlet port 101 and reach a predetermined position, the radicals 136 are carried toward the downstream side by the purge gas 138 so as not to flow further toward the inlet port 101.

The intermediate port 112 and the outlet port 133 are connected to a suction and exhaust means 201 via an exhaust switching valve 202A and an exhaust switching valve 202B, respectively. The suction and exhaust means 201 has a suction pump to forcibly draw and discharge the radicals 136 and the purge gas 138 in the housing 110A to the outside of the housing 110A through the intermediate port 112 and the outlet port 133. The exhaust switching valve 202A, which is interposed between the intermediate port 112 and the suction and exhaust means 201, and the exhaust switching valve 202B, which is interposed between the outlet port 133 and the suction and exhaust means 201, are on-off valves that are separately controlled by the controller 200 to open and close. To perform cleaning for removing the reaction products accumulating in the housing 110A using the radicals 136 and the purge gas 138, the exhaust switching valve 202A and the exhaust switching valve 202B are controlled to be selectively opened and closed by the controller 200. This switching operation allows the discharge path of the radicals 136 and the purge gas 138 to be switched as described below, thereby effectively cleaning the exhaust mechanism 132 in the housing 110A and cleaning the exhaust path from the outlet of the exhaust mechanism 132 to the outlet port 133.

The cleaning operation for removing the reaction products accumulating in the housing 110A is now described. To perform cleaning for removing the reaction products accumulating in the housing 110A, the feeding of process gas through the inlet port 101 is stopped. To increase the effectiveness in removing the reaction products in the housing 110A, the cleaning consists of two separate steps including the cleaning of the exhaust mechanism 132 in the housing 110A and the cleaning of the exhaust path from the outlet of the exhaust mechanism 132 to the outlet port 133.

First, to clean the upstream side of the exhaust mechanism 132 in the housing 110A, the controller 200 controls to open the exhaust switching valve 202A and close the exhaust switching valve 202B, so that the intermediate port 112 is opened and the outlet port 133 is closed. FIG. 1 shows this state. Then, the on-off valve 140A is opened to supply radicals 136 from the radical supply means 135 into the housing 110A through the radical supply port 134A, and the purge gas 138 is supplied from the purge gas supply means 137 into the housing 110A through the purge gas supply port 139. Also, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110A to be drawn and discharged out of the housing 110A through the intermediate port 112.

The radicals 136 supplied into the housing 110A flow in the housing 110A while decomposing and removing the reaction products accumulating in the housing 110A by activating them. The radicals 136 are then discharged out of the housing 110A together with the reaction products and the purge gas 138 to be treated. The purge gas 138 is supplied through the purge gas supply port 139 on the upstream side (the side corresponding to the inlet port 101) in the housing 110A and then discharged out of the housing 110A together with the radicals 136 through the intermediate port 112. The flow of this purge gas 138 carries the radicals 136 flowing in the housing 110A and guides them to the intermediate port 112, thereby stopping the radicals 136 from flowing toward the inlet port 101 with the reaction products beyond a position at a specified height in the housing 110A. That is, the purge gas 138 stops the reaction products decomposed by the radicals 136 from flowing to the turbomolecular pump mechanism portion 301 and accumulating on the upstream side of the turbomolecular pump mechanism portion 301.

This allows the radicals 136 to effectively decompose the reaction products accumulating in the exhaust mechanism 132, and the decomposed gas is discharged out of the housing 110A through the intermediate port 112.

In a cleaning operation of the exhaust mechanism 132, the amount of the purge gas 138 flowing from the purge gas supply means 137 into the housing 110A is about 1,000 sccm, the amount of radicals 136 flowing from the radical supply means 135 into the housing 110A is about 50 sccm, and the power supplied to the radical supply means 135 is about 300 watts (W).

Next, to clean the exhaust path from the outlet of the exhaust mechanism 132 to the outlet port 133 in the housing 110A, the controller 200 controls to close the exhaust switching valve 202A and open the exhaust switching valve 202B, so that the intermediate port 112 is closed and the outlet port 133 is opened. FIG. 2 shows this state. Then, the on-off valve 140A is opened to supply the radicals 136 from the radical supply means 135 into the housing 110A through the radical supply port 134A, and the purge gas 138 is supplied from the purge gas supply means 137 into the housing 110A through the purge gas supply port 139. Also, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110A to be drawn and discharged out of the housing 110A through the outlet port 133. In a cleaning operation of the exhaust mechanism 132 on the downstream side, the amount of the purge gas 138 flowing from the purge gas supply means 137 into the housing 110A is about 50 sccm, the amount of radicals 136 flowing from the radical supply means 135 into the housing 110A is about 50 sccm, and the supplied power is about 300 watts (W).

The radicals 136 supplied into the housing 110A flow in the housing 110A while decomposing and removing the reaction products accumulating in the housing 110A by activating them. The radicals 136 are then discharged out of the housing 110A together with the reaction products and the purge gas 138 to be treated. To clean the downstream side of the exhaust mechanism 132 (the side corresponding to the thread groove pump mechanism portion 302), the purge gas 138 is also supplied from the purge gas supply port 139 on the upstream side in the housing 110A and discharged out of the housing 110A through the outlet port 133 together with the radicals 136. The flow of this purge gas 138 carries the radicals 136 flowing in the housing 110A and guides them to the outlet port 133, thereby stopping the radicals 136 from flowing together with reaction products and dust toward the inlet port 101 beyond a position at a specified height in the housing 110A.

As such, with the turbomolecular pump 100A of the first example configured as described above, the radicals 136 are supplied into the housing 110A through the radical supply port 134A, which is provided between the inlet port 101 and the outlet port 133, to remove the reaction products accumulating in the housing 110A. This allows the supplied radicals 136 to be distributed over the entire area that requires cleaning in the housing 110A and to activate and thus effectively remove the accumulating reaction products. In particular, the cleaning is achieved by separately performing the cleaning of the exhaust mechanism 132 and the cleaning of the exhaust path from the outlet of the exhaust mechanism 132 to the outlet port 133. This minimizes the contact between the radicals 136 and the surfaces of other components that do not require cleaning, allowing the cleaning to be effectively performed through a short path without causing the radicals 136 to become inactive. As a result, the effective removal of reaction products is achieved with a fewer number of radical generators (the radical supply means 135), thereby reducing both the cost for cleaning components of the cleaning system in the turbomolecular pump 100A and the operating costs.

In the cleaning of the inside of the housing 110A of the turbomolecular pump 100A of the first example, to ensure that the decomposed gas does not flow to the inlet port 101 of the housing 110A when the purge gas 138 and the radicals 136 are discharged through the intermediate port 112, an on-off valve may be provided above the inlet port 101 and closed during the cleaning.

Also, during a cleaning operation, the exhaust mechanism 132 may be rotated at a low speed of about 13,500 rpm, for example, which is about half of the rated rotation speed. When the exhaust mechanism 132 is rotated at a low speed, unreacted radicals 136 are less likely to be discharged through the intermediate port 112, allowing the produced radicals 136 to be effectively used. Furthermore, gradually lowering the rotation speed of the exhaust mechanism 132 during cleaning achieves effective cleaning from the vicinity of the outlet port 133 to the inlet port 101. In contrast, when the rotation speed of the exhaust mechanism 132 is too high, unreacted radicals 136 are less likely to reach the upstream side. As such, when the cleaning effect is low on the upstream side in the housing 110A, the rotation speed of the rotating body 103, which is a part of the exhaust mechanism, may be slightly lowered. To further increase the cleaning effect on the upstream side, the rotating body 103, which is a part of the exhaust mechanism, may also be rotated in the reverse direction.

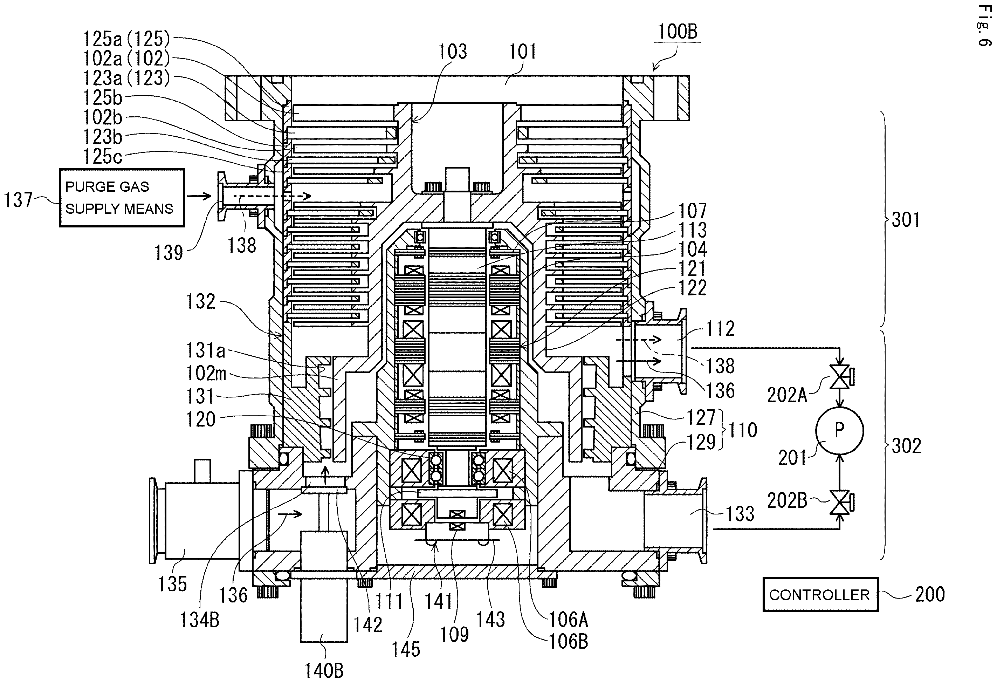

FIG. 6 shows a turbomolecular pump 100B as a second example in which a part of the turbomolecular pump 100A shown in FIGS. 1 and 2 is modified. With the turbomolecular pump 100A shown in FIGS. 1 and 2, the on-off valve 140A, which controls the opening and closing in the supply of radicals 136 from the radical supply means 135, is provided outside the housing 110A. In contrast, with the turbomolecular pump 100B of the second example shown in FIG. 6, a radical supply port 134B, which receives the radicals 136 supplied from the radical supply means 135, and an on-off valve 140B, which controls the opening and closing of the radical supply port 134B, are provided inside the housing 110B. The other configurations and advantageous effects are the same as those of the turbomolecular pump 100A of the first example. As such, in the following description, the same reference numerals are given to the components that are the same as those of the turbomolecular pump 100A of the first example shown in FIGS. 1 and 2. The descriptions of such components are omitted, and only the parts with different structures are described. The housing 110B shown in FIG. 6 corresponds to the housing 110A shown in FIGS. 1 and 2, and the radical supply port 134B also corresponds to the radical supply port 134A shown in FIGS. 1 and 2.

With the turbomolecular pump 100B of the second example shown in FIG. 6, the radical supply port 134B is provided inside the base portion 129 of the housing 110B, and also the on-off valve 140B for opening and closing the radical supply port 134B is arranged such that a part (valve body 142) of the on-off valve 140B projects into the base portion 129. The on-off valve 140B may be a solenoid operated valve, for example. When the valve body 142 is projected from the on-off valve 140B by solenoid operation, the valve body 142 closes the radical supply port 134B and stops the radicals 136 from flowing from the radical supply means 135 into the housing 110B through the radical supply port 134B. It also stops the process gas flowing in the housing 110B from flowing into the radical supply means 135. Conversely, when the valve body 142 is pulled away from the radical supply port 134B (toward the main body of the on-off valve 140B) by solenoid operation, the radical supply port 134B opens and allows the radicals 136 to flow from the radical supply means 135 into the housing 110B through the radical supply port 134B.

The operation of cleaning for removing the reaction products accumulating in the housing 110B of the turbomolecular pump 100B of the second example is now described. To perform cleaning for removing the reaction products accumulating in the housing 110B, the feeding of process gas through the inlet port 101 is also stopped. To increase the effectiveness in removing the reaction products in the housing 110B, the cleaning also consists of two separate steps including the cleaning of the exhaust mechanism 132 in the housing 110B and the cleaning of the exhaust path from the outlet of the exhaust mechanism 132 to the outlet port 133.

First, to clean the exhaust mechanism 132 in the housing 110B, the controller 200 controls to open the exhaust switching valve 202A and close the exhaust switching valve 202B, so that the intermediate port 112 is opened and the outlet port 133 is closed. Then, the valve body 142 of the on-off valve 140B is opened so that the radicals 136 are supplied from the radical supply means 135 into the housing 110B through the radical supply port 134B, and the purge gas 138 is supplied from the purge gas supply means 137 into the housing 110B through the purge gas supply port 139. Also, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110B to be drawn and discharged out of the housing 110B through the intermediate port 112.

The radicals 136 supplied into the housing 110B flow in the housing 110B while decomposing and removing the reaction products accumulating in the housing 110B by activating them. The radicals 136 are then discharged out of the housing 110B together with the reaction products and the purge gas 138 to be treated. The purge gas 138 is supplied through the purge gas supply port 139 on the upstream side (the side corresponding to the inlet port 101) in the housing 110B and then flows out of the housing 110B together with the radicals 136 through the intermediate port 112. The flow of this purge gas 138 carries the radicals 136 flowing in the housing 110B and guides them to the intermediate port 112, thereby stopping the radicals 136 from flowing toward the inlet port 101 with the reaction products beyond a position at a specified height in the housing 110B.

This allows the radicals 136 to effectively decompose the reaction products accumulating in the exhaust mechanism 132, and the decomposed gas is discharged out of the housing 110B through the intermediate port 112.

In the cleaning of the exhaust mechanism 132, the amount of the purge gas 138 flowing from the purge gas supply means 137 into the housing 110B is about 1,000 sccm, the amount of radicals 136 flowing from the radical supply means 135 into the housing 110B is about 50 sccm, and the power supplied to the radical supply means 135 is about 300 watts (W) .

The cleaning of the exhaust path from the outlet of the exhaust mechanism 132 to the outlet port 133 in the housing 110B is now described. To clean the downstream side, the controller 200 controls to close the exhaust switching valve 202A and open the exhaust switching valve 202B, so that the intermediate port 112 is closed and the outlet port 133 is opened. Then, the on-off valve 140B is opened so that the radicals 136 are supplied from the radical supply means 135 into the housing 110B through the radical supply port 134B, and the purge gas 138 is supplied from the purge gas supply means 137 into the housing 110B through the purge gas supply port 139. Also, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110B to be drawn and discharged out of the housing 110B through the outlet port 133. In a cleaning operation of the exhaust path from the outlet of the exhaust mechanism 132 to the outlet port 133, the amount of the purge gas 138 flowing from the purge gas supply means 137 into the housing 110B is about 50 sccm, the amount of radicals 136 flowing from the radical supply means 135 into the housing 110B is about 50 sccm, and the supplied power is about 300 watts (W).

The radicals 136 supplied into the housing 110B flow in the housing 110B while decomposing and removing the reaction products accumulating in the housing 110B by activating them. The radicals 136 are then discharged out of the housing 110B together with the reaction products and the purge gas 138 to be treated. In the cleaning of the downstream side of the exhaust mechanism 132, the purge gas 138 is also supplied through the purge gas supply port 139 on the upstream side in the housing 110B and flows out of the housing 110B together with the radicals 136 through the outlet port 133. The flow of this purge gas 138 carries the radicals 136 flowing in the housing 110B and guides them to the outlet port 133, thereby stopping the radicals 136 from flowing toward the inlet port 101 with the reaction products beyond a position at a specified height in the housing 110B.

As such, with the turbomolecular pump 100B of the second example configured as described above, the radicals 136 are supplied into the housing 110B through the radical supply port 134B, which is provided between the inlet port 101 and the outlet port 133, to remove the reaction products accumulating in the housing 110B. This allows the supplied radicals 136 to be distributed over the entire area that requires cleaning in the housing 110B and to activate and thus effectively remove the accumulating reaction products. In particular, the cleaning is achieved by separately performing the cleaning of the exhaust mechanism 132 and the cleaning of the exhaust path from the outlet of the exhaust mechanism 132 to the outlet port 133. This minimizes the contact between the radicals 136 and the surfaces of other components that do not require cleaning, allowing the cleaning to be effectively performed through a short path without causing the radicals 136 to become inactive. As a result, the effective removal of reaction products is achieved with a fewer number of radical generators (the radical supply means 135), thereby reducing both the cost for cleaning components of the cleaning system in the turbomolecular pump 100B and the operating costs.

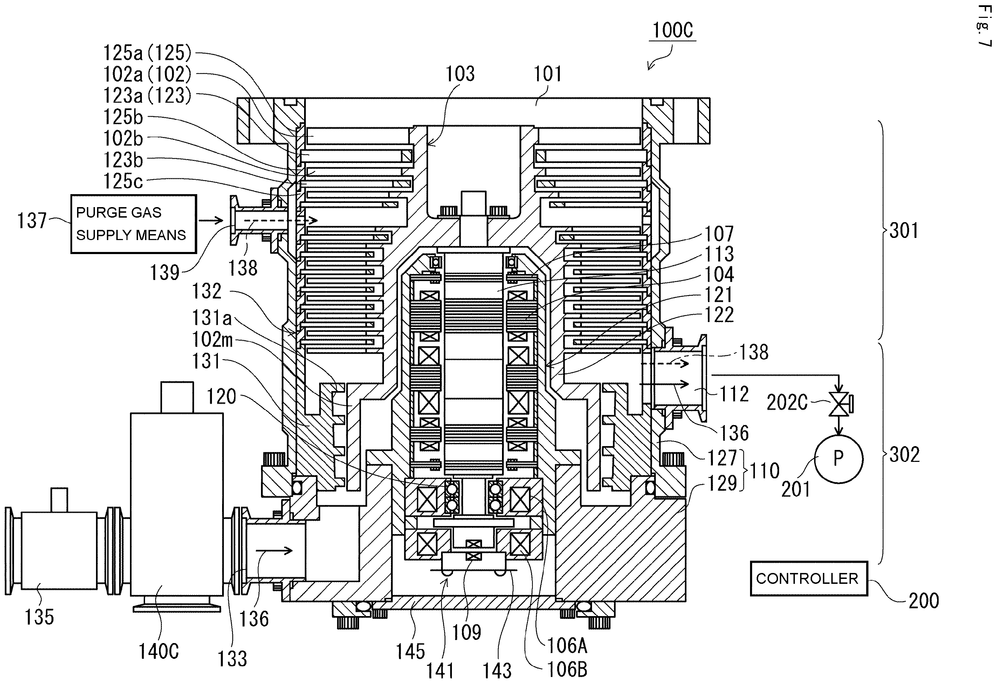

FIG. 7 shows a turbomolecular pump 100C as a third example in which a part of the turbomolecular pump 100A shown in FIGS. 1 and 2 is modified. With the turbomolecular pump 100A shown in FIGS. 1 and 2, the radical supply port 134A is provided between the inlet port 101 and the outlet port 133. In contrast, with the turbomolecular pump 100C of the third example shown in FIG. 7, the radicals 136 are supplied through the outlet port 133. The other configurations and advantageous effects are the same as those of the turbomolecular pump 100A of the first example. As such, in the following description, the same reference numerals are given to the components that are the same as those of the turbomolecular pump 100A of the first example shown in FIGS. 1 and 2. The descriptions of such components are omitted, and only the parts with different structures are described. The housing 110C shown in FIG. 7 corresponds to the housing 110A shown in FIGS. 1 and 2, and the radical supply port 134C also corresponds to the radical supply port 134A shown in FIGS. 1 and 2.

In the turbomolecular pump 100C of the third example shown in FIG. 7, the intermediate port 112 is provided corresponding to a portion substantially at the middle of the exhaust mechanism 132 in the axial direction. More specifically, as shown in FIG. 7, the intermediate port 112 is provided substantially corresponding to a position of the exhaust mechanism 132 between the upstream portion including a plurality of rotor blades 102 arranged in multiple stages in the axial direction and a plurality of stator blades 123 disposed between the rotor blades 102 (the turbomolecular pump mechanism portion 301) and the downstream portion including the cylindrical portion 102m and the thread grooves 131a formed in the inner circumference surface of the threaded spacer 131 facing the outer circumference surface of the cylindrical portion 102m (the thread groove pump mechanism portion 302).

A suction and exhaust means 201 is connected to the intermediate port 112 of the turbomolecular pump 100B via an on-off valve 202C. To perform cleaning, the suction and exhaust means 201 has a suction pump to forcibly draw and discharge the radicals 136 and the purge gas 138 in the housing 110C to the outside of the housing 110C through the intermediate port 112. The controller 200 controls the opening and closing of this on-off valve 202C. To perform cleaning to remove the reaction products accumulating in the housing 110C using the radicals 136 and the purge gas 138, the controller 200 controls to open the on-off valve 202C, and the intermediate port 112 is connected to the suction and exhaust means 201, so that the gas in the housing 110C is drawn and discharged out of the housing 110C. As a result, the exhaust mechanism 132 and the like in the housing 110C are effectively cleaned.

The operation of cleaning for removing the reaction products accumulating in the housing 110C is now described. To clean the exhaust mechanism 132 and the like in the housing 110C, the controller 200 controls to switch the on-off valve 202C from close to open. Then, a three-way valve 140C is switched so that the radicals 136 are supplied into the housing 110C from the radical supply means 135 through the outlet port 133. Also, the purge gas 138 is supplied into the housing 110C from the purge gas supply means 137 through the purge gas supply port 139. Additionally, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110C to be discharged out of the housing 110C through the intermediate port 112.

The radicals 136 supplied into the housing 110C flow in the housing 110C while decomposing and removing the reaction products accumulating in the housing 110C by activating them. The radicals 136 are then discharged out of the housing 110C together with the reaction products and the purge gas 138 to be treated. The purge gas 138 is supplied through the purge gas supply port 139 on the upstream side (the side corresponding to the inlet port 101) in the housing 110C and then flows out of the housing 110C together with the radicals 136 through the intermediate port 112. The flow of this purge gas 138 carries the radicals 136 flowing in the housing 110C and guides them to the intermediate port 112, thereby stopping the radicals 136 from flowing toward the inlet port 101 with the reaction products beyond a position at a specified height in the housing 110C. Accordingly, the configuration of the third example adjusts the amount of the purge gas 138 flowing from the purge gas supply means 137 into the housing 110C and the amount of the radicals 136 flowing from the radical supply means 135 into the housing 110C while keeping a balance between these amounts, thereby controlling the flow of radicals 136 flowing with reaction products toward the upstream side of the housing 110C. The cleaning area in the housing 110C is set by adjusting the height positions of the purge gas 138 and the radicals 136 so that the cleaning is performed within the set area.

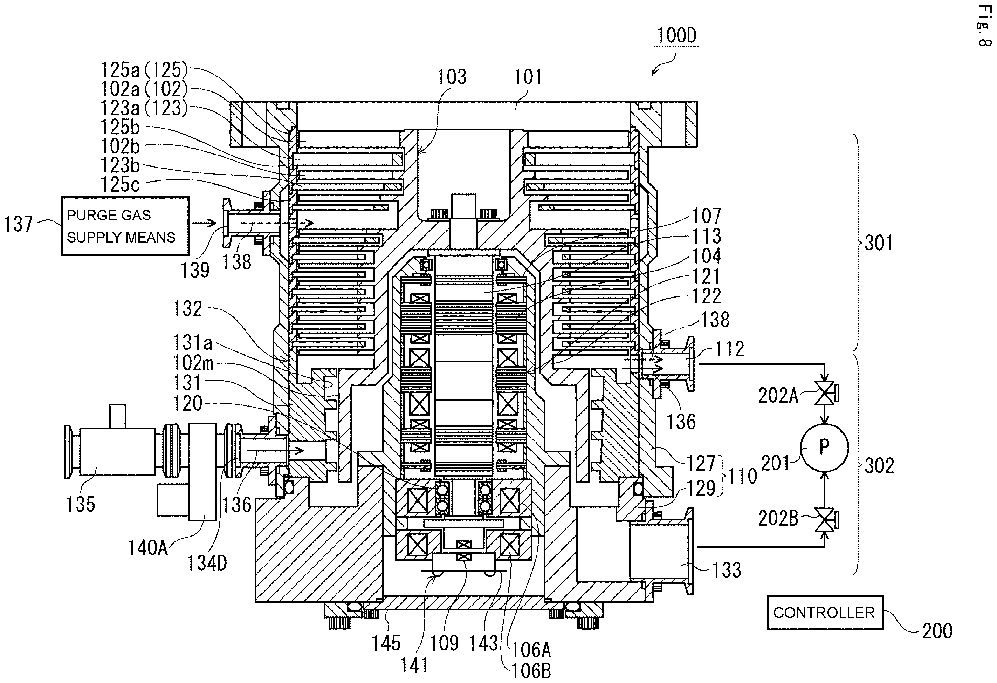

FIG. 8 shows a turbomolecular pump 100D as a fourth example in which a part of the turbomolecular pump 100A shown in FIGS. 1 and 2 is modified. With the turbomolecular pump 100A shown in FIGS. 1 and 2, the radical supply port 134A is provided at a position that is substantially at the same height as the outlet port 133 in the axial direction of the exhaust mechanism 132. In contrast, with the turbomolecular pump 100D of the fourth example shown in FIG. 8, the radical supply port 134D is provided at a position that is above the outlet port 133 and substantially corresponds to the downstream portion (the thread groove pump mechanism portion 302) of the exhaust mechanism 132 that includes the cylindrical portion 102m and the thread grooves 131a formed in the inner circumference surface of the threaded spacer 131 facing the outer circumference surface of the cylindrical portion 102m. The other configurations and advantageous effects are the same as those of the turbomolecular pump 100A of the first example. As such, in the following description, the same reference numerals are given to the components that are the same as those of the turbomolecular pump 100A of the first example shown in FIGS. 1 and 2. The descriptions of such components are omitted, and only the parts with different structures are described. The housing 110D shown in FIG. 8 corresponds to the housing 110A shown in FIGS. 1 and 2, and the radical supply port 134D also corresponds to the radical supply port 134A shown in FIGS. 1 and 2.

The radical supply port 134D of the turbomolecular pump 100D of the fourth example shown in FIG. 8 is provided at a position that is above the outlet port 133 and substantially corresponds to the downstream portion (the thread groove pump mechanism portion 302) of the exhaust mechanism 132 that includes the cylindrical portion 102m and the thread grooves 131a formed in the inner circumference surface of the threaded spacer 131 facing the outer circumference surface of the cylindrical portion 102m. Also, the radical supply port 134D is arranged on the outer circumference surface of the threaded spacer 131 so as to extend through the housing 110D and the threaded spacer 131.

The operation of cleaning for removing the reaction products accumulating in the housing 110D of the turbomolecular pump 100D of the fourth example is now described. To perform cleaning for removing the reaction products accumulating in the housing 110D, the feeding of process gas through the inlet port 101 is also stopped.

To clean the upstream side of the radical supply port 134D in the turbomolecular pump 100D of the fourth example, the controller 200 controls to open the exhaust switching valve 202A and close the exhaust switching valve 202B, so that the intermediate port 112 is opened and the outlet port 133 is closed. Then, the on-off valve 140A is opened so that the radicals 136 are supplied from the radical supply means 135 into the housing 110D through the radical supply port 134D, and the purge gas 138 is supplied from the purge gas supply means 137 into the housing 110D through the purge gas supply port 139. Also, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110D to be drawn and discharged out of the housing 110D through the intermediate port 112.

The radicals 136 supplied into the housing 110D flow in the housing 110D while decomposing and removing the reaction products accumulating in the exhaust mechanism 132 by activating them. The radicals 136 are then discharged out of the housing 110D together with the reaction products and the purge gas 138 to be treated. The purge gas 138 is supplied through the purge gas supply port 139 on the upstream side (the side corresponding to the inlet port 101) in the housing 110D and then flows out of the housing 110D together with the radicals 136 through the intermediate port 112. The flow of this purge gas 138 carries the radicals 136 flowing in the housing 110D and guides them to the intermediate port 112, thereby stopping the radicals 136 from flowing toward the inlet port 101 with the reaction products beyond a position at a specified height in the housing 110D.

This allows the radicals 136 to effectively decompose the reaction products accumulating in a large area of the housing 110D from the downstream side (the outlet port 133) to a predetermined height position beyond the intermediate port 112 on the upstream side, and the decomposed gas is discharged out of the housing 110D through the intermediate port 112.

In the cleaning of the exhaust mechanism 132 on the upstream side, the amount of the purge gas 138 flowing from the purge gas supply means 137 into the housing 110D is about 1,000 sccm, the amount of radicals 136 flowing from the radical supply means 135 into the housing 110D is about 50 sccm, and the power supplied to the radical supply means 135 is about 300 watts (W).

To perform cleaning concentrating on the area on the downstream side of the radical supply port 134D, the controller 200 controls to close the exhaust switching valve 202A and open the exhaust switching valve 202B, so that the intermediate port 112 is closed and the outlet port 133 is opened. Then, the on-off valve 140A is opened so that the radicals 136 are supplied from the radical supply means 135 into the housing 110D through the radical supply port 134D, and the purge gas 138 is supplied from the purge gas supply means 137 into the housing 110D through the purge gas supply port 139. Also, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110D to be drawn and discharged out of the housing 110D through the outlet port 133. In the cleaning of the exhaust mechanism 132 on the downstream side, the amount of the purge gas 138 flowing from the purge gas supply means 137 into the housing 110D is about 50 sccm, the amount of radicals 136 flowing from the radical supply means 135 into the housing 110D is about 50 sccm, and the supplied power is about 300 watts (W).

The radicals 136 supplied into the housing 110D flow in the housing 110D while decomposing and removing the reaction products accumulating in the housing 110D by activating them. The radicals 136 are then discharged out of the housing 110D together with the reaction products and the purge gas 138 to be treated. In the cleaning of the downstream side (the thread groove pump mechanism portion 302) of the exhaust mechanism 132, the purge gas 138 is also supplied through the purge gas supply port 139 on the upstream side in the housing 110D and flows out of the housing 110D together with the radicals 136 through the outlet port 133. The flow of this purge gas 138 carries the radicals 136 flowing in the housing 110D and guides them to the outlet port 133, thereby stopping the radicals 136 from flowing toward the inlet port 101 with the reaction products beyond a position at a specified height in the housing 110D.

As such, with the turbomolecular pump 100D of the fourth example configured as described above, the radicals 136 are supplied into the housing 110D through the radical supply port 134D, which is provided between the inlet port 101 and the outlet port 133, to remove the reaction products accumulating in the housing 110D. This allows the supplied radicals 136 to be distributed over the entire area that requires cleaning in the housing 110D and to activate and thus effectively remove the accumulating reaction products. In particular, the cleaning is achieved by separately performing the cleaning of the upstream side of the radical supply port 134D and the cleaning of the downstream side of the radical supply port 134D. This minimizes the contact between the radicals 136 and the surfaces of other components that do not require cleaning, allowing the cleaning to be performed without causing the radicals 136 to become inactive. As a result, the effective removal of reaction products is achieved with a fewer number of radical generators (the radical supply means 135), thereby reducing both the cost for cleaning components of the cleaning system in the turbomolecular pump 100D and the operating costs.

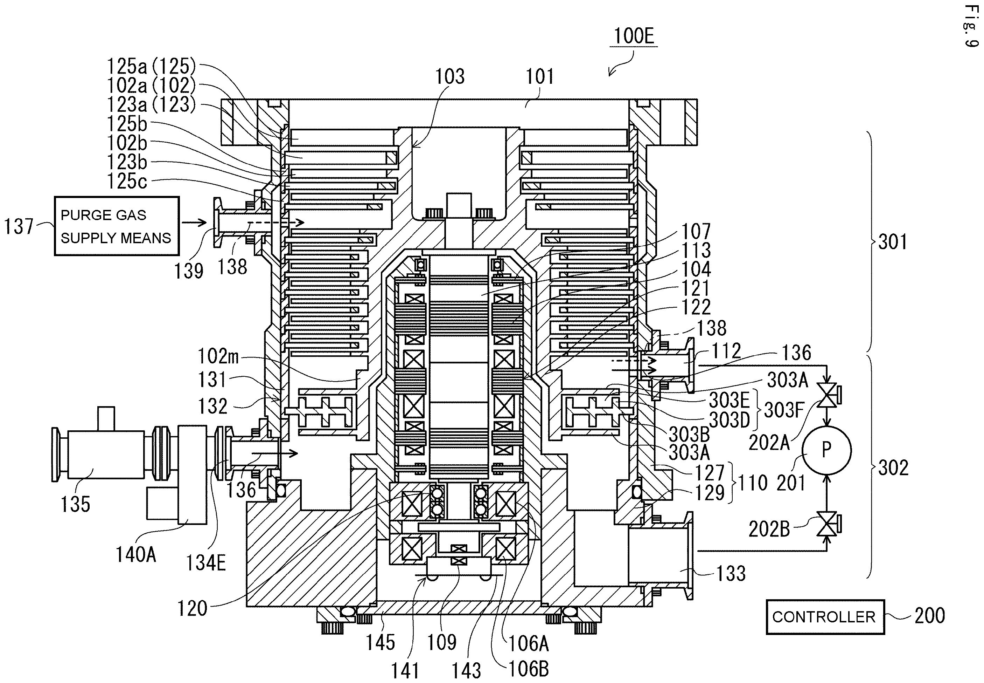

FIG. 9 shows a turbomolecular pump 100E as a fifth example in which a part of the turbomolecular pump 100A shown in FIGS. 1 and 2 is modified. The turbomolecular pumps 100A, 100B, 100C, and 100D separately shown in FIGS. 1, 2, 6, 7, and 8 each have the thread groove pump mechanism portion 302 that is a Holweck type pump mechanism. In contrast, the turbomolecular pump 100E of the fifth example shown in FIG. 9 has a Siegbahn type pump mechanism. The other configurations and advantageous effects are the same as those of the turbomolecular pump 100A of the first example. As such, in the following description, the same reference numerals are given to the components that are the same as those of the turbomolecular pump 100A of the first example shown in FIGS. 1 and 2. The descriptions of such components are omitted, and only the parts with different structures are described. The housing 110E shown in FIG. 9 corresponds to the housing 110A shown in FIGS. 1 and 2, and the radical supply port 134E also corresponds to the radical supply port 134A shown in FIGS. 1 and 2.

In the turbomolecular pump 100E shown in FIG. 9, in which the thread groove pump mechanism portion 302 is configured as a Siegbahn type pump mechanism, the thread groove pump mechanism portion 302 includes rotating discs 302A and a stator disc 302B mutually facing in the axial direction. A thread groove 302F is formed on each of the two surfaces of the stator disc 302B facing the rotating discs 302A. The thread groove 302F is a spiral groove formed by a spiral ridge portion 302D and a spiral root portion 302E.

The intermediate port 112 of the turbomolecular pump 100E shown in FIG. 9 extends through the housing 110E in the vicinity of the boundary between the turbomolecular pump mechanism portion 301 and the thread groove pump mechanism portion 302, which is configured as a Siegbahn type pump mechanism. The radical supply port 134E of the turbomolecular pump 100E extends through the housing 110E at a position that is above the outlet port 133 and substantially corresponds to the lower side (the lower surface of a rotating disc 302A) of the downstream portion of the exhaust mechanism 132.

The operation of cleaning for removing the reaction products accumulating in the housing 110E of the turbomolecular pump 100E of the fifth example is now described. To perform a cleaning operation for removing the reaction products accumulating in the housing 110E, the feeding of process gas through the inlet port 101 is also stopped.

To clean the area from the downstream side to the upstream side in the housing 110E of the turbomolecular pump 100E of the fifth example, the controller 200 controls to open the exhaust switching valve 202A and close the exhaust switching valve 202B, so that the intermediate port 112 is opened and the outlet port 133 is closed. Then, the on-off valve 140A is opened so that the radicals 136 are supplied from the radical supply means 135 into the housing 110E through the radical supply port 134E, and the purge gas 138 is supplied from the purge gas supply means 137 into the housing 110E through the purge gas supply port 139. Also, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110E to be drawn and discharged out of the housing 110E through the intermediate port 112.

The radicals 136 supplied into the housing 110E flow in the housing 110E while decomposing and removing the reaction products accumulating in the housing 110E by activating them. The radicals 136 are then discharged out of the housing 110E together with the reaction products and the purge gas 138 to be treated. The purge gas 138 is supplied through the purge gas supply port 139 on the upstream side (the side corresponding to the inlet port 101) in the housing 110E and then flows out of the housing 110E together with the radicals 136 through the intermediate port 112. The flow of this purge gas 138 carries the radicals 136 flowing in the housing 110E and guides them to the intermediate port 112, thereby stopping the radicals 136 from flowing toward the inlet port 101 with the reaction products beyond a position at a specified height in the housing 110E.

This allows the radicals 136 to effectively decompose the reaction products accumulating in a large area of the housing 110E from the downstream side (the outlet port 133) to a predetermined height position beyond the intermediate port 112 on the upstream side, and the decomposed gas is discharged out of the housing 110E through the intermediate port 112.

In the cleaning of the exhaust mechanism 132 on the upstream side, the amount of the purge gas 138 flowing from the purge gas supply means 137 into the housing 110E is about 1,000 sccm, the amount of radicals 136 flowing from the radical supply means 135 into the housing 110E is about 50 sccm, and the power supplied to the radical supply means 135 is about 300 watts (W).

Next, to perform cleaning concentrating only on the area on the downstream side (the portion of the Siegbahn type pump mechanism in this example) of the exhaust mechanism 132 in the housing 110E, the controller 200 controls to close the exhaust switching valve 202A and open the exhaust switching valve 202B, so that the intermediate port 112 is closed and the outlet port 133 is opened. Then, the on-off valve 140A is opened so that the radicals 136 are supplied from the radical supply means 135 into the housing 110E through the radical supply port 134E, and the purge gas 138 is supplied from the purge gas supply means 137 into the housing 110E through the purge gas supply port 139. Also, the suction and exhaust means 201 is driven in accordance with the supply of the radicals 136 from the radical supply means 135 and the supply of the purge gas 138 from the purge gas supply means 137, causing the radicals 136 and the purge gas 138 supplied into the housing 110E to be drawn and discharged out of the housing 110E through the outlet port 133. In the cleaning of the exhaust mechanism 132 on the downstream side, the amount of the purge gas 138 flowing from the purge gas supply means 137 into the housing 110E is about 50 sccm, the amount of radicals 136 flowing from the radical supply means 135 into the housing 110E is about 50 sccm, and the supplied power is about 300 watts (W).

The radicals 136 supplied into the housing 110E flow in the housing 110E while decomposing and removing the reaction products accumulating in the housing 110E by activating them. The radicals 136 are then discharged out of the housing 110E together with the reaction products and the purge gas 138 to be treated. In the cleaning of the downstream side (the portion of the Siegbahn type pump mechanism in this example) of the exhaust mechanism 132, the purge gas 138 is also supplied through the purge gas supply port 139 on the upstream side in the housing 110E and flows out of the housing 110E together with the radicals 136 through the outlet port 133. The flow of this purge gas 138 carries the radicals 136 flowing in the housing 110E and guides them to the outlet port 133, thereby stopping the radicals 136 from flowing toward the inlet port 101 with the reaction products beyond a position at a specified height in the housing 110E.

As such, with the turbomolecular pump 100E of the fifth example configured as described above, the radicals 136 are supplied into the housing 110E through the radical supply port 134E, which is provided between the inlet port 101 and the outlet port 133, to remove the reaction products accumulating in the housing 110E. This allows the supplied radicals 136 to be distributed over the entire area that requires cleaning in the housing 110E and to activate and thus effectively remove the accumulating reaction products. In particular, the cleaning is achieved by separately performing the cleaning of the upstream side and the cleaning of the downstream side of the exhaust mechanism 132. This minimizes the contact between the radicals 136 and the surfaces of other components that do not require cleaning, allowing the cleaning to be performed without causing the radicals 136 to become inactive. As a result, the effective removal of reaction products is achieved with a fewer number of radical generators (the radical supply means 135), thereby reducing both the cost for cleaning components of the cleaning system in the turbomolecular pump 100E and the operating costs.

It should be noted that the present invention is amenable to various modifications and combinations within the spirit of the invention, and the invention is intended to cover all modifications and combinations.

In the examples described above, the radical supply means 135 is placed outside the turbomolecular pump 100A-100E. However, a radical generator may be incorporated into the housing 110A-100E.

- 100A: Turbomolecular pump
- 100B: Turbomolecular pump
- 100C: Turbomolecular pump
- 100D: Turbomolecular pump
- 100E: Turbomolecular pump
- 101: Inlet port
- 102: Rotor blade
- 102m: Cylindrical portion
- 103: Rotating body (exhaust mechanism)
- 110A: Housing
- 110B: Housing
- 110C: Housing
- 110D: Housing
- 110E: Housing
- 112: Intermediate port
- 113: Rotor shaft
- 123: Stator blade
- 123a: Stator blade
- 123b: Stator blade
- 123c: Stator blade
- 125: Stator blade spacer
- 127: Outer cylinder
- 129: Base portion
- 131: Threaded spacer
- 131a: Thread groove
- 132: Exhaust mechanism
- 133: Outlet port
- 134A: Radical supply port
- 134B: Radical supply port
- 134C: Radical supply port
- 134D: Radical supply port
- 134E: Radical supply port
- 135: Radical supply means
- 136: Radical
- 137: Purge gas supply means
- 138: Purge gas
- 139: Purge gas supply port
- 140A: On-off valve
- 140B: On-off valve
- 140C: Three-way valve
- 200: Controller
- 201: Suction and exhaust means
- 202A: Exhaust switching valve
- 202B: Exhaust switching valve
- 202C: On-off valve
- 301: Turbomolecular pump mechanism portion
- 302: Thread groove pump mechanism portion
- 302A: Rotating disc
- 302B: Stator disc
- 302D: Spiral ridge portion
- 302E: Spiral root portion
- 302F: Thread groove

## Claims

1. A vacuum pump comprising:
a housing having an inlet port and an outlet port; and
an exhaust mechanism disposed inside the housing,
the vacuum pump further comprising:
a radical supply port that is disposed adjacent to an exhaust side outlet of the exhaust mechanism and provided to extend through the housing; and
a radical supply means for supplying radicals into the housing through the radical supply port and causing the supplied radicals to flow to an area in which reaction products accumulate in the exhaust mechanism.

2. The vacuum pump according to claim 1, further comprising an intermediate port located between the inlet port and the radical supply port to discharge the radicals to outside of the housing.

3. The vacuum pump according to claim 2, further comprising:
a suction and exhaust means capable of drawing the radicals supplied into the housing through the outlet port or the intermediate port and discharging the radicals to outside of the housing; and
an exhaust switching valve capable of switching a discharge path of the radicals to the outlet port or the intermediate port.

4. The vacuum pump according to claim 1, wherein at least a part of the exhaust mechanism is a turbomolecular pump mechanism including a rotating body having a plurality of rotor blades arranged in multiple stages in an axial direction and a plurality of stator blades disposed between the plurality of rotor blades.

5. The vacuum pump according to claim 1, wherein at least a part of the exhaust mechanism is a Siegbahn type pump mechanism including a rotating disc, a stator disc, and a spiral groove provided in at least a part of an opposed surface of the stator disc facing the rotating disc.

6. The vacuum pump according to claim 1, wherein at least a part of the exhaust mechanism is a Holweck type pump mechanism including a rotating cylinder, a stator cylinder, and a thread groove provided in at least a part of an opposed surface of the stator cylinder facing the rotating cylinder.

7. The vacuum pump according to claim 2, wherein
the exhaust mechanism is constituted of at least two of a turbomolecular pump mechanism including a rotating body having a plurality of rotor blades arranged in multiple stages in an axial direction and a plurality of stator blades disposed between the plurality of rotor blades, a Siegbahn type pump mechanism including a rotating disc, a stator disc, and a spiral groove provided in at least a part of an opposed surface of the stator disc facing the rotating disc, or a Holweck type pump mechanism including a rotating cylinder, a stator cylinder, and a thread groove provided in at least a part of an opposed surface of the stator cylinder facing the rotating cylinder, and
the intermediate port is disposed in a vicinity of a boundary between adjacent ones of the turbomolecular pump mechanism, the Siegbahn type pump mechanism, or the Holweck type pump mechanism.

8. A vacuum exhaust system comprising:
a vacuum pump including
a housing having an inlet port and an outlet port,
an exhaust mechanism disposed inside the housing, and
a radical supply port that is disposed adjacent to an exhaust side outlet of the exhaust mechanism and provided to extend through the housing; and
a radical supply means for supplying radicals into the housing through the radical supply port and causing the supplied radicals to be supplied to an area in which reaction products accumulate in the exhaust mechanism.
